# EUROPEAN PATENT SPECIFICATION

(11) **EP 4 415 041 B1**
(45) Date of publication and mention of the grant of the patent: **05.11.2025**
(21) Application number: 23866624.2
(22) Date of filing: 26.09.2023
(51) Int. Cl.: H01L 23/48, H01L 23/31, H01L 21/56, H01L 21/768, H01L 23/36, H01L 23/367, H01L 23/373, H01L 23/538, H05K 1/02, H01L 23/13, H01L 23/433, H01L 23/498

(54) **ELECTRONIC PACKAGE, MANUFACTURING METHOD FOR ELECTRONIC PACKAGE AND ELECTRONIC DEVICE**
ELEKTRONISCHES GEHÄUSE, HERSTELLUNGSVERFAHREN FÜR ELEKTRONISCHES GEHÄUSE UND ELEKTRONISCHE VORRICHTUNG
BOÎTIER ÉLECTRONIQUE, PROCÉDÉ DE FABRICATION DE BOÎTIER ÉLECTRONIQUE ET DISPOSITIF ÉLECTRONIQUE

(30) Priority: 20.12.2022 CN 202211646358
(43) Date of publication of application: 14.08.2024
(73) Proprietor: Chengdu Haiguang Integrated Circuit Design Co., Ltd., Chengdu, Sichuan 610216 (CN)
(72) Inventor: DU, Shuan, Chengdu, Sichuan 610216 (CN); QIAN, Xiaofeng, Chengdu, Sichuan 610216 (CN); YANG, Xiaojun, Chengdu, Sichuan 610216 (CN); GUO, Rui, Chengdu, Sichuan 610216 (CN); YANG, Liu, Chengdu, Sichuan 610216 (CN)
(74) Representative: Maiwald GmbH
(86) International application number: PCT/CN2023/121380
(87) International publication number: WO 2024/131183

(56) References cited:
- EP-A1- 2 555 240
- CN-A- 107 734 839
- CN-A- 113 013 116
- CN-A- 116 053 232
- KR-A- 20130 077 564
- US-A1- 2012 075 807
- US-A1- 2015 228 553
- US-A1- 2016 105 960
- US-A1- 2016 302 308
- US-A1- 2018 102 311
- US-A1- 2021 335 698
- US-A1- 2022 068 750

## Description

### TECHNICAL FIELD

Embodiments of the present disclosure relate to an electronic packaging, a manufacturing method for an electronic packaging and an electronic apparatus.

### BACKGROUND

In electronic packaging, an embedded substrate can be arranged on a base substrate, and high-density interconnection between different dies can be realized through the embedded substrate.

Since signal lines on the embedded substrate usually are connected at a relatively greater density, it is easy to result in high temperature due to accumulation, which may affect a quality of signal transmission.

US2016/302308A1 discloses a printed circuit board, an electronic component module and a method of manufacturing the same. The printed circuit board includes a circuit board including a through hole and a first circuit pattern, and a connection board having a microcircuit structure including a second circuit pattern, the connection board accommodated in the through hole.

US2016/105960A1 discloses a multilayer wiring board, the multilayer wiring board includes a main wiring board including insulation layers, first via conductors formed in the insulation layers, and a first conductive layer including first mounting pads such that the first mounting pads are positioned to mount a first electronic component and a second electronic component adjacent to each other on the main wiring board, and a wiring structure body mounted on the main wiring board such that the wiring structure body is positioned in an outermost insulation layer of the insulation layers, the wiring structure body including a second conductive layer which includes second mounting pads such that the second mounting pads are positioned to connect to the first electronic component and the second electronic component mounted on the main wiring board. The first via conductors are formed such that the first via conductors have diameters which increase in a same direction.

EP2555240A1 discloses a packaging substrate including a carrier and an interposer. The carrier has opposite top and bottom surfaces. A recess is disposed in the top surface and a plurality of first conductive terminals are disposed on the bottom of the recess. Further, a plurality of second conductive terminals are disposed on the bottom surface of the carrier. The interposer is disposed in the recess and has opposite first and second surfaces and a plurality of conductive through vias penetrating the first and second surfaces. A first conductive pad is disposed on an end of each of the conductive through vias exposed from the first surface, and a second conductive pad is disposed on the other end of the conductive through via exposed from the second surface and electrically connected to a corresponding one of the first conductive terminals. Compared with the prior art, the invention improves the product reliability.

CN107734839A relates to the technical field of PCB structures, discloses a PCB. The PCB includes a substrate, a metal block, and a heat dissipating hole; the substrate has a stepped groove; the metalblock is arranged in the stepped groove and same as the stepped groove in shape, and a heat conduction medium is arranged between the top surface of the metal block and a component; the heat dissipating hole is formed in the substrate, and the heat dissipating hole and the metal block can be used for heat conduction. By forming a groove in the PCB, embedding the metal block making direct contactwith the component and forming the heat dissipating hole which can be used for heat conduction with the metal block, heat generated by the component and heat in a metal layer in the PCB can be timelyand rapidly dissipated, the heat dissipation performance of the PCB is improved, and the service life of the PCB and the component is prolonged.

US2015/228553A1 discloses Flip chip packages including two or more thermal interface materials (TIMs). A die is mounted to a substrate by solder bumps. A first TIM is applied to the die, and has a first thermal resistance. A second TIM is applied to the die and/or the substrate, and has a second thermal resistance that is greater than the first thermal resistance. An open end of a heat spreader lid is mounted to the substrate such that the die is positioned in an enclosure formed by the heat spreader lid and substrate. The first TIM and the second TIM are each in contact with an inner surface of the heat spreader lid. A ring-shaped stiffener may surround the die and be connected between the substrate and heat spreader lid by the second TIM.

US2018/102311A1 discloses a semiconductor package. The semiconductor package includes a resin molded package substrate comprising a resin molded core, a plurality of metal vias in the resin molded core, a front-side RDL structure, and a backside RDL structure. A bridge TSV interconnect component is embedded in the resin molded core. The bridge TSV interconnect component has a silicon substrate portion, an RDL structure integrally constructed on the silicon substrate portion, and TSVs in the silicon substrate portion. A first semiconductor die and a second semiconductor die are mounted on the front-side RDL structure. The first semiconductor die and the second semiconductor die are coplanar.

US2012/075807A1 discloses a method of manufacturing which includes placing a thermal management device in thermal contact with a first semiconductor chip of a semiconductor chip device. The semiconductor chip device includes a first substrate coupled to the first semiconductor chip. The first substrate has a first aperture. At least one of the first semiconductor chip and the thermal management device is at least partially positioned in the first aperture.

### SUMMARY

It is an objective of the present disclosure to provide an electronic packaging, a manufacturing method for an electronic packaging, and an electronic apparatus, which facilitates improving the quality of signal transmission between dies.

The objective is achieved by the respective independent claims. Further embodiments are defined in the dependent claims.

### BRIEF DESCRIPTION OF DRAWINGS

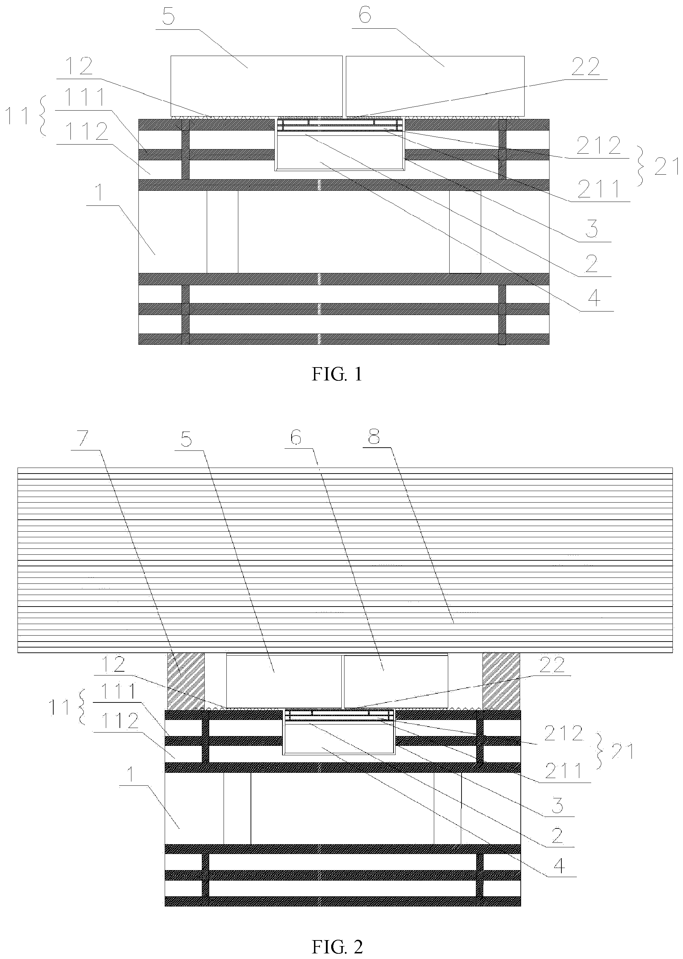

In order to more clearly illustrate the technical solutions of the embodiments of the present disclosure, the drawings necessary for the description of the embodiments will be briefly described in the following; it is obvious that the described drawings are only related to some embodiments of the present disclosure, and other drawings can be obtained according to these drawings without creative work for those ordinary skilled in the art. The embodiments described in relation with Figures 1 to 3 do not form part of the invention but are useful to understand it.
FIG. 1 is a schematic diagram of an electronic packaging in some embodiments of the present disclosure;
FIG. 2 is a schematic diagram of a second heat sink on a package substrate in some embodiments of the present disclosure;
FIG. 3 is a schematic diagram of an interconnect substrate in some embodiments of the present disclosure;
FIG. 4 is a schematic diagram of an electronic packaging in some other embodiments of the present disclosure;
FIG. 5 is a top view of a package substrate provided with a recess in some embodiments of the present disclosure;
FIG. 6 is a top view of a package substrate provided with a recess in some other embodiments of the present disclosure;
FIG. 7 is a schematic diagram of an electronic packaging in still some other embodiments of the present disclosure;
FIGS. 8A-8G are schematic diagrams of a manufacturing process for an electronic packaging in some embodiments of the present disclosure;
FIG. 9 is a flowchart of a manufacturing method for an electronic packaging in some embodiments of the present disclosure;
FIG. 10 is a schematic diagram of an electronic apparatus in some embodiments of the present disclosure;
FIG. 11 is a schematic diagram of an electronic apparatus in some other embodiments of the present disclosure; and
FIG. 12 is a schematic diagram of an electronic apparatus in still some other embodiments of the present disclosure.

### DETAILED DESCRIPTION

Hereinafter, the embodiments of the present disclosure will be described in details with reference to the accompanying drawings.

It should be clear that the described embodiments are only part of the embodiments of the present disclosure, but not all the embodiments. Based on the embodiments in the present disclosure, all other embodiments obtained by ordinary skilled in the art without creative work belong to the scope of protection of the present disclosure.

FIG. 1 is a schematic diagram of an electronic packaging in some embodiments of the present disclosure. Referring to FIG. 1, the electronic packaging provided by the embodiments of the present disclosure includes a package substrate 1 and an interconnect substrate 2; a recess 3 is arranged on a first surface of the package substrate 1, and the interconnect substrate 2 is embedded in the recess 3; a first heat sink 4 is arranged at a bottom of the interconnect substrate 2; a first die 5 and a second die 6 are arranged on the first surface of the package substrate 1; the first die 5 and the second die 6 are electrically connected through the interconnect substrate 2.

In some examples, the package substrate 1 may be an Ajinomoto Build-up Film substrate, which is abbreviated as ABF substrate in English. The recess 3 can be provided on the first surface (e.g., an upper surface) of the package substrate 1 by a photolithography process, a laser trenching process or the like. The package substrate 1 may further include an adhesive layer, which may be located between the first heat sink 4 and a bottom of the recess 3; and the bottom of the interconnect substrate 2 is fixed on the first heat sink 4 by means of the adhesive layer, so that the interconnect substrate 2 is embedded in the recess 3. The adhesive layer can be made of a double-sided die attach film (DAF). The first heat sink 4 can also be referred to as a first heat sink, a first thermal conductive member or the like. A material of the first heat sink 4 can be copper, aluminum alloy or the like.

In this embodiment, since the first heat sink 4 is arranged at the bottom of the interconnect substrate 2, it is convenient to dissipate heat from the interconnect substrate 2 through the first heat sink 4, which is beneficial to improving the quality of signal transmission between the first die 5 and the second die 6.

Moreover, with the decrease of the temperature of the interconnect substrate 2, heat would be transferred from a location with a higher temperature to a location with a lower temperature under a natural state, so that the heat on the first die 5 and the second die 6 can be transferred to the interconnect substrate 2, thereby reducing the temperature of the first die 5 and the second die 6, and also enabling the performance of the first die 5 and the second die 6 to be more stable.

FIG. 2 is a schematic diagram of a second heat sink 8 on the package substrate 1 in some embodiments of the present disclosure. Referring to FIG. 2, in an embodiment, the electronic packaging further includes a stiffener ring 7 arranged on the package substrate 1; the first die 5 and the second die 6 are arranged in a space surrounded by the stiffener ring 7.

The stiffener ring 7 is also referred to as a support ring. The stiffener ring 7 can be circular-shaped or rectangular-shaped, and a material of the stiffener ring 7 can be copper, aluminum alloy or the like. The stiffener ring 7 can be bonded and fixed onto the first surface of the package substrate 1 by means of a glue cured at high temperature, and can also be welded onto the first surface of the package substrate 1 by means of a solder. In order to further improve the thermal dissipation efficiency of the dies, referring to FIG. 2, in an embodiment, the electronic packaging further includes a second heat sink 8 supported on the stiffener ring 7, and the second heat sink 8 corresponds to the first die 5 and the second die 6; that is, the second heat sink 8 covers the first die 5 and the second die 6 from right above the first die 5 and the second die 6. In some examples, the second heat sink 8 may be a heat sink, such as a profiled heat sink, a stacked heat sink and the like. The second heat sink 8 can be press-fitted at the top of the stiffener ring 7 by a force clamp, and a height of the stiffener ring 7 can be slightly greater than a height of the first die 5 and the second die 6, so as to prevent the second heat sink 8 from compressing the first die 5 and the second die 6.

Heat generated by the first die 5 and the second die 6 can be dissipated from the top of the first die 5 and the top of the second die 6 through the second heat sink 8.

In this embodiment, heat can be dissipated from bottoms and tops of the first die 5 and the second die 6 by means of the first heat sink 4 at the bottom of the interconnect substrate 2 and the second heat sink 8 arranged at the tops of the first die 5 and the second die 6, respectively, thereby further improving the thermal dissipation efficiency for the first die 5 and the second die 6.

An incomplete contact may exist among the stiffener ring 7, the first die 5, the second die 6 and the second heat sink 8. When there is a certain gap among the stiffener ring 7, the first die 5, the second die 6 and the second heat sink 8, a large thermal resistance may exist. In some examples, a thermal conductive material (not shown in the figure) can be arranged among the stiffener ring 7, the first die 5, the second die 6 and the second heat sink 8, which can effectively reduce the thermal resistance among the stiffener ring 7, the first die 5, the second die 6 and the second heat sink 8. In this way, the heat generated by the stiffener ring 7, the first die 5 and the second die 6 can be quickly transferred to the second heat sink 8. The thermal conductive material can be thermal conductive silicone grease, thermal conductive paste or the like.

The first die 5 and the second die 6 are located in a closed space surrounded by the interconnect substrate 2, the stiffener ring 7, the thermal conductive material and the second heat sink 8 on the package substrate 1. In some examples, the stiffener ring 7, the thermal conductive material and the second heat dissipating member 8 can not only dissipate heat from the first die 5 and the second die 6, but also protect the first die 5 and the second die 6.

In some embodiments, the package substrate 1 includes a first interconnect layer 11 in which the first recess 31 is arranged, and the first interconnect layer 11 includes first metal wiring layers 111 and first dielectric layers 112 which are alternately stacked; the interconnect substrate 2 includes a second interconnect layer 21, and the second interconnect layer 21 includes second metal wiring layers and second dielectric layers which are alternately stacked; the second dielectric layer includes an organic material, and an arrangement density of the second metal wiring layers is greater than an arrangement density of the first metal wiring layers 111.

The arrangement density refers to a line spacing between two adjacent metal traces. It can be seen that the wirings on the interconnect substrate 2 is denser than that on the package substrate 1, which can realize high-density interconnection of signal lines between the first die 5 and the second die 6 and is convenient to increase a bandwidth of signal transmission, thus reducing a delay of signal transmission between the first die 5 and the second die 6 and reducing an overall energy consumption.

In some examples, in the first metal wiring layer 111, a line width and a line spacing of metal lines can be 12 um, respectively; in the second metal wiring layer, a width of a single metal trace is 0.5 um-5 um, and a spacing between two adjacent metal traces is 0.5 um-5 um.

In some embodiments, the organic material includes polyimide, so that when the interconnect substrate 2 is machined, there is no need to adopt a traditional silicon process for the processing equipment and the processing environment, thus reducing the production cost.

In some embodiments, the package substrate 1 further includes a plurality of first connection bumps 12 located on an upper surface of the first interconnect layer 11, and the first die 5 and the second die 6 are electrically connected with the package substrate 1 through the first connection bumps 12; the interconnect substrate 2 further includes a plurality of second connection bumps located on an upper surface of the second interconnect layer 21, and a part of the first die 5 and a part of the second die 6 are electrically connected with the interconnect substrate 2 through the second connection bumps.

In some examples, the first connection bump 12 and the second connection bump may be spherical-shaped connection bumps. The first connection bump 12 may include a first copper pillar and a first solder ball arranged at the end of the first copper pillar; and the first copper pillar is electrically connected with the first interconnect layer 11 on the package substrate 1. The second connection bump may include a second copper pillar and a second solder ball arranged at the end of the second copper pillar; and the second copper pillar is electrically connected with the second interconnect layer 21 on the interconnect substrate 2.

In some examples, the first die 5 may include a third connection bump (not shown in the figure) corresponding to the first connection bump 12, and the third connection bump may include a third copper pillar and a third solder ball arranged at the end of the third copper pillar. By soldering the third solder ball and the first solder ball one by one, the first die 5 can be electrically connected with the package substrate 1. The first die 5 may further include a fourth connection bump (not shown in the figure) corresponding to the second connection bump, and the fourth and third connection bumps are located in different areas on a same surface of the first die 5. The fourth connection bump may include a fourth copper pillar and a fourth solder ball arranged at the end of the fourth copper pillar. By soldering the fourth solder ball and the second solder ball one by one, the first die 5 can be electrically connected with the interconnect substrate 2.

In some examples, the second die 6 may include a fifth connection bump (not shown in the figure) corresponding to the first connection bump 12, and the fifth connection bump may include a fifth copper pillar and a fifth solder ball arranged at the end of the fifth copper pillar. By soldering the fifth solder ball and the first solder ball one by one, the second die 6 can be electrically connected with the package substrate 1. The second die 6 may also include a sixth connection bump (not shown in the figure) corresponding to the second connection bump, and the sixth and fifth connection bumps are located in different areas on a same surface of the second die 6. The sixth connection bump may include a sixth copper pillar and a sixth solder ball arranged at the end of the sixth copper pillar. By soldering the sixth solder ball and the second solder ball one by one, the second die 6 can be electrically connected with the interconnect substrate 2.

In some embodiments, at least one of the following is satisfied between the second connection bump and the first connection bump 12: a width of the second connection bump (in a direction parallel to the base substrate) is smaller than a width of the first connection bump 12; and a distance between adjacent second connection bumps is smaller than a distance between adjacent first connection bumps 12.

In some examples, the width of the second connection bump is smaller than the width of the first connection bump 12, which may be the case that a diameter of the second connection bump is smaller than a diameter of the first connection bump 12.

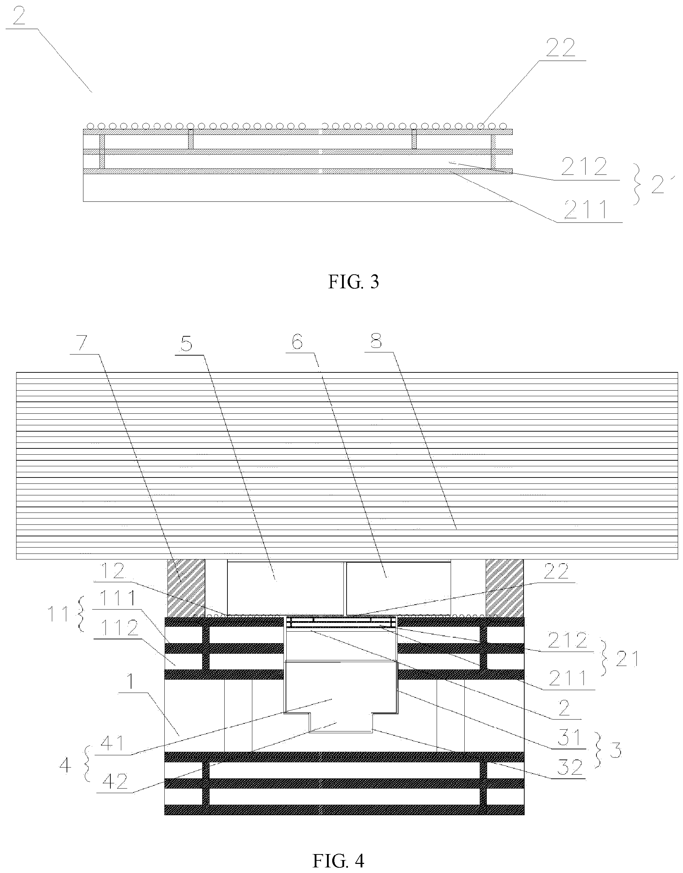

FIG. 4 is a schematic diagram of an electronic packaging. Referring to FIG. 4, the electronic packaging has a structure basically the same as that of the embodiment shown in FIG. 2, except that in the electronic packaging of this embodiment, the recess 3 on the package substrate 1 includes a first recess 31 and a second ecess 32 connected with each other, and a width (in a direction parallel to the base substrate) of the second recess 32 is smaller than a width of the first recess 31; the first heat sink 4 is supported in the second recess 32, and at least part of the first heat sink 4 is arranged in the first recess 31, and the interconnect substrate 2 is arranged in the first recess 31 and supported on the first heat sink 4.

The width of the second recess 32 is smaller than the width of the first recess 31, which may be the case that a cross-sectional area of the second recess 32 is smaller than a cross-sectional area of the first recess 31. The cross-sectional area refers to the cross-sectional area perpendicular to a central axis thereof.

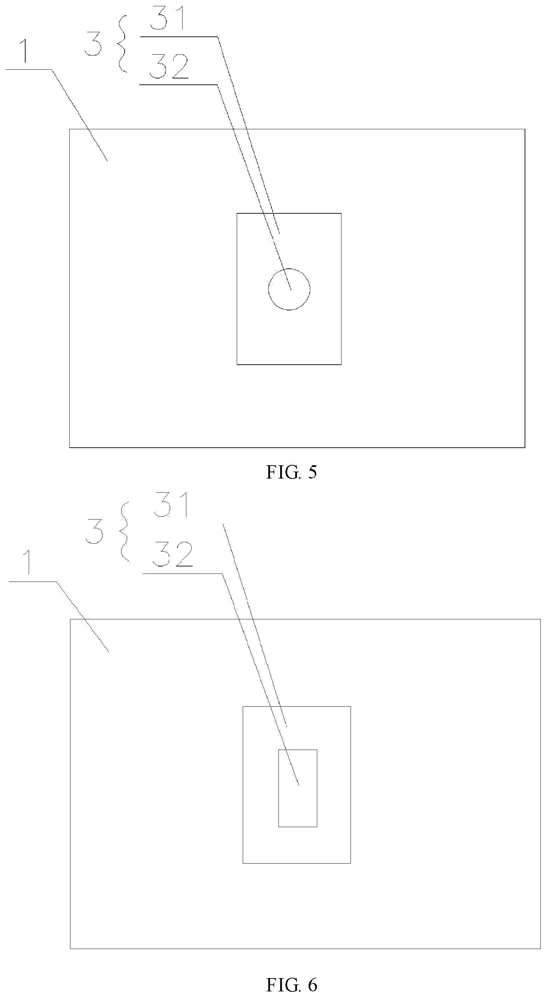

The second recess 32 is located below the first recess 31; and the second recess 32 and the first recess 31 may have a same shape or have different shapes. Referring to FIG. 5, the second recess 32 is cylindrical-shaped, and the first recess 31 is rectangular-shaped. Referring to FIG. 6, both the second recess 32 and the first recess 31 are rectangular-shaped.

An accuracy of the second recess 32 may be smaller than an accuracy of the first recess 31. The first recess 31 can be formed on the first surface of the package substrate 1 by a photolithography process, a laser trenching process or the like, so that the first recess 31 is a high-precision recess 3; the second recess 32 can be formed at a recess bottom of the first recess 31 by way of mechanical processing, such as a milling process.

By forming the second recess 32 at the recess bottom of the first recess 31, a volume of the first heat sink 4 can be increased, and the heat absorption capacity of the first heat sink 4 can be improved. The first heat sink 4 can absorb the heat conducted to the interconnect substrate 2 by the first die 5 and the second die 6, and can also absorb the heat generated by the package substrate 1 at the same time, thereby serving for thermal dissipation of the package substrate 1 as well. In addition, since the width of the second recess 32 is smaller than that of the first recess 31, by supporting the first heat sink 4 in the second recess 32, the installation and positioning during placing the first heat sink 4 in the recess 3 can be facilitated.

Referring to FIG. 4, the first heat sink 4 includes a first thermal dissipation part 41 and a second thermal dissipation part 42, the first thermal dissipation part 41 is connected with the second thermal dissipation part 42, and a width of the second thermal dissipation part 42 is smaller than a width of the first thermal dissipation part 41; the second thermal dissipation part 42 is arranged in the second recess 32, and the first thermal dissipation part 41 is arranged in the first recess 31 and supported on a stair at a transitional junction between the first recess 31 and the second recess 32; the interconnect substrate 2 is supported on the first thermal dissipation part 41.

The width of the second thermal dissipation part 42 is smaller than the width of the first thermal dissipation part 41, which may be the case that a cross-sectional area of the second thermal dissipation part 42 perpendicular to a central axis thereof is smaller than a cross-sectional area of the first thermal dissipation part 41 perpendicular to a central axis thereof. The first heat sink 4 can be fabricated by one-piece molding process.

A shape of the second thermal dissipation part 42 can be adapted to a shape of the second recess 32; and a shape of the first thermal dissipation part 41 can be adapted to a shape of the first recess 31.

A stair surface at a transitional junction between the second thermal dissipation part 42 and the first thermal dissipation part 41 of the first heat sink 4 can be bonded onto the stair at the transitional junction between the first recess 31 and the second recess 32 by using a double-sided die attach film (DAF), which is then cured there at high temperature.

The first heat sink 4 includes a first thermal dissipation part 41 and a second thermal dissipation part 42; the second thermal dissipation part 42 is arranged in the second recess 32, and the first thermal dissipation part 41 is arranged in the first recess 31 and supported on the stair at the transitional junction between the first recess 31 and the second recess 32. In this way, a contact area between the first heat sink 4 and the package substrate 1 can be increased; correspondingly, the first thermal dissipation part 41 can absorb the heat generated by the package substrate 1 more effectively at the same time when absorbing the heat conducted to the interconnect substrate 2 through the first die 5 and the second die 6, so that a better thermal dissipation effect for the package substrate 1 and the interconnect substrate 2 can be achieved.

A thermal conductive material, such as thermal conductive silicone grease and thermal conductive paste, may be provided at the top of the first thermal dissipation part 41, so as to improve the thermal dissipation efficiency for the interconnect substrate 2.

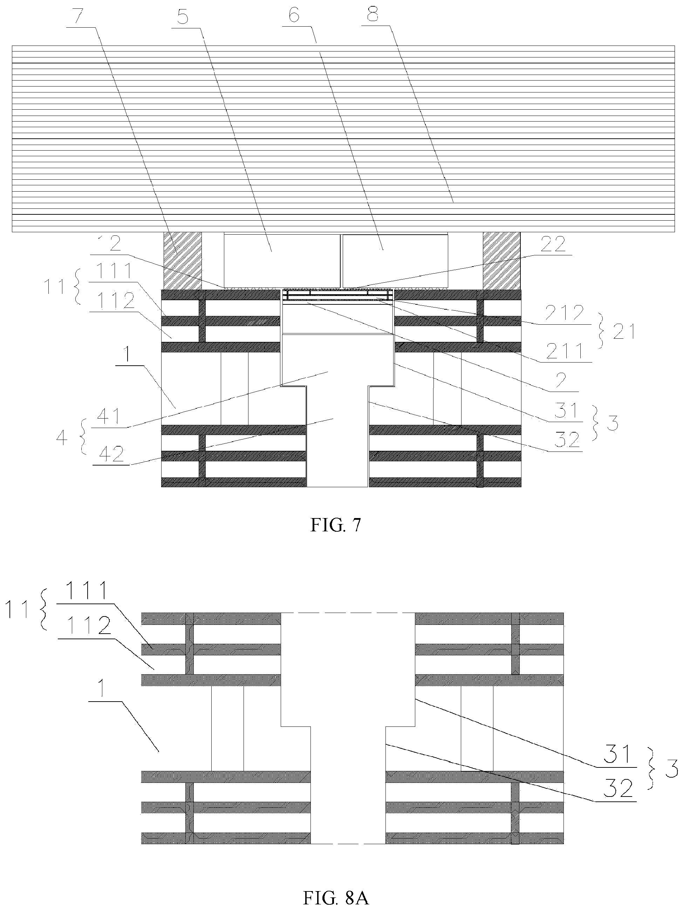

FIG. 6 is a schematic diagram of an electronic packaging in some embodiments of the present disclosure. Referring to FIG. 7, the electronic packaging of this embodiment has a structure basically the same as that shown in FIG. 2, except that in the electronic packaging of this embodiment, the second recess 32 penetrates through a second surface of the package substrate 1 in addition to the second recess 32 being connected with the first recess 31.

In this embodiment, the second thermal dissipation part 42 of the first heat sink 4 located in the second recess 32 penetrates through the second surface of the package substrate 1, and can dissipate the heat absorbed by the first heat sink 4 to the outside of the package substrate 1, so as to further enhance the thermal dissipation effect of the first heat sink 4 for the interconnect substrate 2 (the heat of the interconnect substrate 2 mainly comes from the first die 5 and the second die 6) and the package substrate 1, thereby improving the thermal dissipation efficiency for the first die 5 and the second die 6.

In an embodiment, the electronic packaging further includes a thermal dissipation hole, which is arranged in the second thermal dissipation part 42 of the first heat sink 4 at least along an axial direction of the first heat sink 4.

The electronic packaging may include a plurality of thermal dissipation holes. The plurality of thermal dissipation holes can be blind holes, and a length of each thermal dissipation hole can penetrate deeply into the first thermal dissipation part 41. In this way, cold air can enter the thermal dissipation holes and take away the heat absorbed by the first heat sink 4. In an example, the plurality of thermal dissipation holes may include a first thermal dissipation hole and a second thermal dissipation hole, and ends of the first thermal dissipation hole and the second thermal dissipation hole that penetrate deeply into the first thermal dissipation part 41 are connected with each other, thus facilitating the formation of a convection channel for cold air and improving the thermal dissipation efficiency.

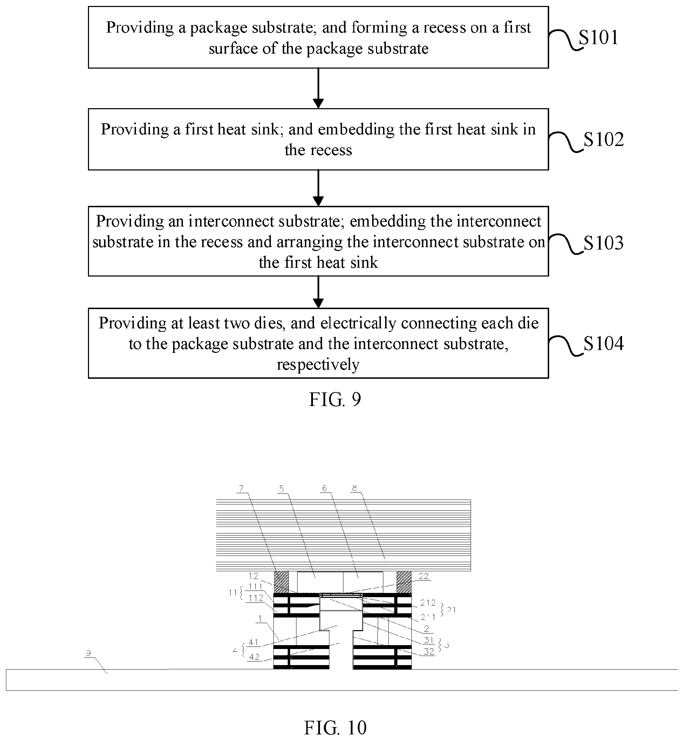

An embodiment of the present disclosure provides a manufacturing method for an electronic packaging, which is used for manufacturing the electronic packaging described above. As shown in FIGS. 8A to 8G and FIG. 9, the manufacturing method includes the following steps.

S101, providing a package substrate 1; and forming a recess 3 on a first surface of the package substrate 1.

S1011, forming a first recess 31 on the first surface of the package substrate 1;

S1012, forming a second recess 32 at a recess bottom of the first recess 31; wherein the first recess 31 is connected with the second recess 32, and a width of the second recess 32 is smaller than a width of the first recess 31.

S102, providing a first heat sink 4; and embedding the first heat sink 4 in the recess 3;

S103, providing an interconnect substrate 2; embedding the interconnect substrate 2 in the recess 3 and arranging the interconnect substrate 2 on the first heat sink 4;

S104, providing at least two dies, and electrically connecting each die to the package substrate 1 and the interconnect substrate 2, respectively.

For specific processing steps corresponding to this step, reference can be made to FIGS. 8A to 8E.

A first recess 31 is formed on the first surface of the package substrate 1 by a photolithography process, and a second recess 32 can be formed at the recess bottom of the first recess 31 by a milling process. The second recess 32 penetrates through the second surface of the package substrate 1, as shown in FIG. 8A, in which a cross-sectional area of the second recess 32 perpendicular to a central axis thereof is smaller than a cross-sectional area of the first recess 31 perpendicular to a central axis thereof.

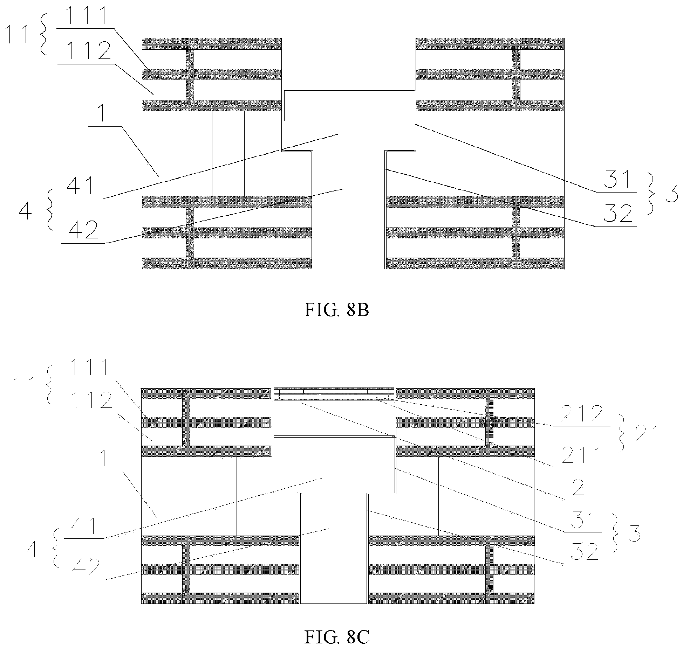

A double-sided die attach film (DAF) can be bonded onto a stair at a transitional junction between the first recess 31 and the second recess 32, and the second thermal dissipation part 42 of the first heat sink 4 can be put into the second recess 32 after passing through the first recess 31, so that a bottom of the first thermal dissipation part 41 of the first heat sink 4 can be bonded with the aforementioned stair through the double-sided die attach film (DAF), which is then cured at high temperature, as shown in FIG. 8B, in which the top of the first thermal dissipation part 41 is kept in a horizontal direction.

A double-sided die attach film (DAF) with high thermal conductivity can be bonded onto the top of the first thermal dissipation part 41, and the interconnect substrate 2 can be placed in the first recess 31, so that the interconnect substrate 2 can be bonded with the top of the second heat sink 8 through the double-sided die attach film (DAF) with high thermal conductivity, which is then cured at high temperature, as shown in FIG. 8C.

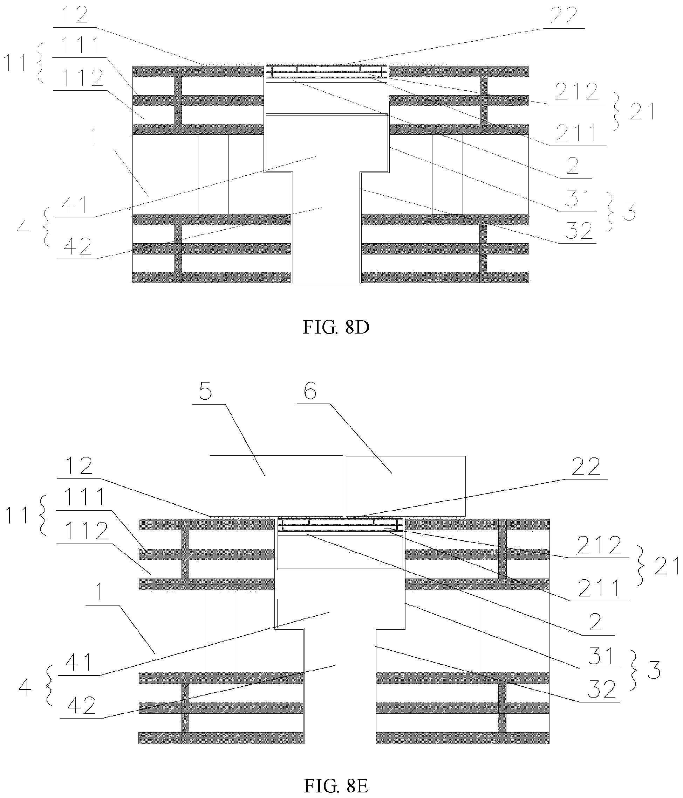

Copper pillars and solder balls can be electroplated onto the package substrate 1 and the interconnect substrate 2 to obtain a first connection bump 12, a second connection bump, a third connection bump and a fourth connection bump, as shown in FIG. 8D, in which the first connection bump 12 is electrically connected with a second connection layer, the second connection bump is electrically connected with a third connection layer, the third connection bump is electrically connected with a first end of a first connection layer, and the fourth connection bump is electrically connected with a second end of the first connection layer.

By means of a reflow soldering process, a first part of the first die 5 can be electrically connected with the third connection bump, a second part of the first die 5 can be electrically connected with the first connection bump 12, a first part of the second die 6 can be electrically connected with the fourth connection bump, and a second part of the second die 6 can be electrically connected with the second connection bump, as shown in FIG. 8E.

In some examples, the package substrate 1 and the interconnect substrate 2 are cleaned and dried, and the above-described first connection bump 12, second connection bump, third connection bump and fourth connection bump are underfilled with an underfill glue.

In the manufacturing method for the electronic packaging of the embodiments of the present disclosure, since the first heat sink 4 is arranged at the bottom of the interconnect substrate 2, it is convenient to dissipate heat from the interconnect substrate 2 through the first heat sink 4, which is beneficial to improving the quality of signal transmission between the first die 5 and the second die 6.

In addition, as the decrease of the temperature of the interconnect substrate 2, heat will be transferred from a location with a higher temperature to a location with a lower temperature under a natural state, so that the heat on the first die 5 and the second die 6 can be transferred to the interconnect substrate 2, thereby lowering the temperature of the first die 5 and the second die 6 and enabling the performance of the first die 5 and the second die 6 to be more stable.

Forming the second recess 32 at the recess bottom of the first recess 31 includes: forming the second recess 32 penetrating through the second surface of the package substrate 1 at the recess bottom of the first recess 31.

As mentioned above, by forming the second recess 32 penetrating through the second surface of the package substrate 1, the second thermal dissipation part 42 of the first heat sink 4 located in the second recess 32 can penetrate through the second surface of the package substrate 1, so that the heat absorbed by the first heat sink 4 can be dissipated to the outside of the package substrate 1 to further enhance the thermal dissipation effect of the first heat sink 4 for the interconnect substrate 2 (the heat of the interconnect substrate 2 mainly comes from the first die 5 and the second die 6) and the package substrate 1, thereby improving the thermal dissipation efficiency for the first die 5 and the second die 6.

In some embodiments, after the first die 5 and the second die 6 are arranged on the package substrate 1, the method further includes: providing a stiffener ring 7; fixing the stiffener ring 7 on the package substrate 1; providing a second heat sink 8 and supporting the second heat sink 8 on the stiffener ring 7, in which the second heat sink 8 corresponds to the at least two dies.

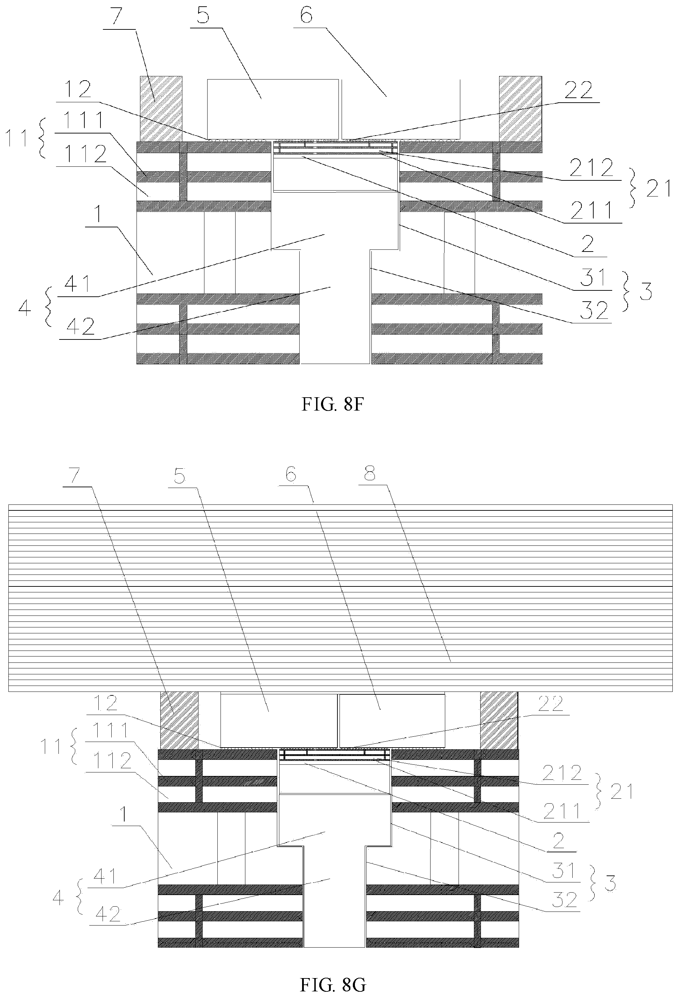

For specific processing steps corresponding to this step, reference can be made to FIGS. 8F to 8G.

An adhesive glue is coated at a position where the stiffener ring 7 is to be placed on the package substrate 1, then the stiffener ring 7 is placed on the package substrate 1 and is bonded with the package substrate 1 through the adhesive glue which is cured at high temperature, as shown in FIG. 8F.

The tops of the stiffener ring 7, the first die 5 and the second die 6 are coated with thermal conductive silicone grease or graphene or indiums; the second heat sink 8 is placed on the tops of the stiffener ring 7, the first die 5 and the second die 6 from above of the first die 5 and the second die 6; and the second heat sink 8 is pressed to be in close and tight contact with the tops of the stiffener ring 7, the first die 5 and the second die 6 through force clamps, as shown in FIG. 8G.

In this embodiment, by means of the first heat sink 4 at the bottom of the interconnect substrate 2 and the second heat sink 8 arranged at the tops of the first die 5 and the second die 6, heat can be dissipated from the bottom and the top of the first die 5 and of the second die 6, and the thermal dissipation efficiency for the first die 5 and the second die 6 is further improved.

FIG. 10 is a schematic diagram of an electronic apparatus in some embodiments of the present disclosure. Referring to FIG. 10, this embodiment provides an electronic apparatus including the electronic packaging described in any of the previous embodiments; and a motherboard 9 for an assembly of the electronic packaging; the electronic packaging is electrically connected with the motherboard 9 through the package substrate 1. The motherboard 9 can also be referred to as a master board or a main board, and a plurality of electronic packages can be arranged on the motherboard 9. The beneficial effects of the electronic apparatus in this embodiment are basically the same as those of the electronic packaging therein, which will not be repeated here.

Referring to FIG. 10, in an example, the motherboard 9 is provided with a first through hole 10 at a position corresponding to the recess 3. Air convection can be formed in the first through hole 10, so that cold air can continuously flow into the first through hole 10, and hot air in the first through hole 10 can be continuously exhausted, thereby achieving a thermal dissipation of the package substrate 1. Since an air convection can be formed in the first through hole 10 to reduce the temperature of the package substrate 1, a temperature difference between the package substrate 1 and the first heat sink 4 can be increased, so that the first through hole 10 can enhance the thermal dissipation effect of the first heat sink 4 for the interconnect substrate 2.

Further, a fan may be provided at a side of the motherboard 9 where the electronic packaging is not provided, so as to enhance the air convection effect in the first through hole 10, thereby improving the thermal dissipation effect of the first heat sink 4 for the interconnect substrate 2.

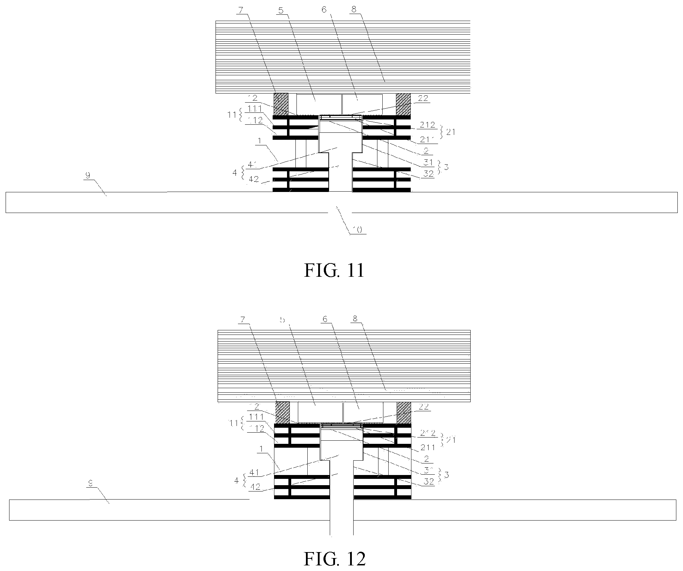

FIG. 11 is a schematic diagram of an electronic apparatus in some embodiments of the present disclosure. Referring to FIG. 11, in an example, the recess 3 penetrates through the second surface of the package substrate 1 and is connected with the first through hole 10, so that the airflow entering the first through hole 10 directly contacts with the first heat sink 4 to provide thermal dissipation efficiency of the first heat sink 4.

FIG. 12 is a schematic diagram of an electronic apparatus in some embodiments of the present disclosure. Referring to FIG. 12, further to the example shown in FIG. 11, the first heat sink 4 can be protruded into the first through hole 10 from the package substrate 1. In this way, a volume of the first heat sink 4 can be increased to enhance the thermal dissipation effect of the first heat sink 4 for the interconnect substrate 2. Referring to FIG. 12, a length of the second thermal dissipation part 42 of the first heat sink 4 can also extend out of the first through hole 10 to increase a contact area with cold air, and to further enhance the thermal dissipation effect.

It should be noted that in the present disclosure, solutions described among various embodiments are focused differently, but there is a certain correlation between the various embodiments, which can be used for reference when understanding the disclosed solution; in addition, relational terms such as first and second are only used to distinguish one entity or operation from another entity or operation, and do not necessarily require or imply any such actual relationship or order between these entities or operations. Moreover, the terms "including", "comprising" or any other variations thereof are intended to cover non-exclusive inclusions, so that a process, method, article or equipment including a series of elements includes not only those elements, but also other elements not explicitly listed or elements inherent to such process, method, article or equipment. Without further restrictions, an element defined by the phrase "including one..." does not exclude the existence of other identical elements in the process, method, article or equipment including the element.

## Claims

1. An electronic packaging, comprising a package substrate (1) and an interconnect substrate (2), wherein a first surface of the package substrate (1) is provided with a recess (3) in which the interconnect substrate (2) is embedded; and a bottom of the interconnect substrate (2) is provided with a first heat sink (4);
the first surface of the package substrate (1) is provided with a first die (5) and a second die (6); the first die (5) and the second die (6) are electrically connected through the interconnect substrate (2), wherein
the recess (3) comprises a first recess (31) and a second recess (32), the first recess (31) is connected with the second recess (32), and a width of the second recess (32) is smaller than a width of the first recess (31),
the first heat sink (4) comprises a first thermal dissipation part (41) and a second thermal dissipation part (42); the first thermal dissipation part (41) is connected with the second thermal dissipation part (42), and a width of the second thermal dissipation part (42) is smaller than a width of the first thermal dissipation part (41),
the second thermal dissipation part (42) is arranged in the second recess (32), and the first thermal dissipation part (41) is arranged in the first recess (31) and supported on a stair at a transitional junction between the first recess (31) and the second recess (32), and
the interconnect substrate (2) is supported on the first thermal dissipation part (41).

2. The electronic packaging according to claim 1, wherein the second recess (32) penetrates through a second surface of the package substrate (1).

3. The electronic packaging according to claim 2, further comprising a thermal dissipation hole, which is arranged in the second thermal dissipation part (42) of the first heat sink (4) at least along an axial direction of the first heat sink (4).

4. The electronic packaging according to any one of claims 1-3, further comprising: a stiffener ring (7) arranged on the package substrate (1); the first die (5) and the second die (6) are arranged in a space surrounded by the stiffener ring (7).

5. The electronic packaging according to claim 4, further comprising a second heat sink (8) supported on the stiffener ring (7), wherein the second heat sink (8) corresponds to the first die (5) and the second die (6).

6. The electronic packaging according to claim 1, wherein,
the package substrate (1) comprises:
a first interconnect layer (11), wherein the first recess (31) is arranged in the first interconnect layer (11), and the first interconnect layer (11) comprises first metal wiring layers (111) and first dielectric layers (112) which are alternately stacked;
the interconnect substrate (2) comprises:
a second interconnect layer (21), comprising second metal wiring layers and second dielectric layers which are alternately stacked, wherein the second dielectric layer comprises an organic material, and an arrangement density of the second metal wiring layers is greater than an arrangement density of the first metal wiring layers (111),
preferably, the organic material comprises polyimide.

7. The electronic packaging according to claim 6, wherein the package substrate (1) further comprises:
a plurality of first connection bumps (12) located on an upper surface of the first interconnect layer (11), wherein a first chip, a second chip and a third chip are electrically connected with the package substrate (1) through the first connection bumps (12);
the interconnect substrate (2) further comprises a plurality of second connection bumps located on an upper surface of the second interconnect layer (21), wherein a part of the first chip and a part of the second chip are electrically connected with the interconnect substrate (2) through the second connection bumps.

8. The electronic packaging according to claim 7, wherein,
a width of the second connection bump is smaller than a width of the first connection bump (12); and/or a distance between adjacent second connection bumps is smaller than a distance between adjacent first connection bumps (12).

9. An electronic apparatus, comprising the electronic packaging according to any one of claims 1-8, and a motherboard (9) for an assembly of the electronic packaging,
wherein the electronic packaging is electrically connected with the motherboard (9) through the package substrate (1).

10. The electronic apparatus according to claim 9, wherein the motherboard (9) is provided with a first through hole (10) at a position corresponding to the recess (3),
preferably, the recess (3) penetrates through a second surface of the package substrate (1) and is connected with the first through hole (10),
further preferably, the first heat sink (4) is protruded into the first through hole (10) from the package substrate (1).

11. A manufacturing method for an electronic packaging, comprising:
providing a package substrate (1), and forming a recess (3) on a first surface of the package substrate (1);
providing a first heat sink (4), and embedding the first heat sink (4) in the recess (3);
providing an interconnect substrate (2), embedding the interconnect substrate (2) in the recess (3), and arranging the interconnect substrate (2) on the first heat sink (4); and
providing at least two dies, and electrically connecting each of the at least two dies with the package substrate (1) and the interconnect substrate (2), respectively,
wherein the forming the recess (3) on the first surface of the package substrate (1) comprises:
forming a first recess (31) on the first surface of the package substrate (1); and
forming a second recess (32) at a recess bottom of the first recess (31);
wherein the first recess (31) is connected with the second recess (32), and a width of the second recess (32) is smaller than a width of the first recess (31), wherein
the first heat sink (4) comprises a first thermal dissipation part (41) and a second thermal dissipation part (42); the first thermal dissipation part (41) is connected with the second thermal dissipation part (42), and a width of the second thermal dissipation part (42) is smaller than a width of the first thermal dissipation part (41),
the second thermal dissipation part (42) is arranged in the second recess (32), and the first thermal dissipation part (41) is arranged in the first recess (31) and supported on a stair at a transitional junction between the first recess (31) and the second recess (32), and
the interconnect substrate (2) is supported on the first thermal dissipation part (41).

12. The manufacturing method for an electronic packaging according to claim 11, wherein the forming the second recess (32) at the recess bottom of the first recess (31) comprises:
forming the second recess (32) penetrating through a second surface of the package substrate (1) at the recess bottom of the first recess (31).

13. The manufacturing method for an electronic packaging according to claim 11 or 12, further comprising:
providing a stiffener ring (7) and fixing the stiffener ring (7) on the package substrate (1); and
providing a second heat sink (8) and supporting the second heat sink (8) on the stiffener ring (7),
wherein the second heat sink (8) corresponds to the at least two dies.

## Patentansprüche

1. Elektronisches Gehäuse umfassend ein Gehäusesubstrat (1) und ein Verbindungssubstrat (2), wobei eine erste Oberfläche des Gehäusesubstrats (1) mit einer Aussparung (3) versehen ist, in die das Verbindungssubstrat (2) eingebettet ist; und ein Boden des Verbindungssubstrats (2) mit einem ersten Kühlkörper (4) versehen ist;
die erste Oberfläche des Gehäusesubstrats (1) mit einem ersten Chip (5) und einem zweiten Chip (6) versehen ist; der erste Chip (5) und der zweite Chip (6) durch das Verbindungssubstrat (2) elektrisch verbunden sind, wobei
die Aussparung (3) eine erste Aussparung (31) und eine zweite Aussparung (32) umfasst, die erste Aussparung (31) mit der zweiten Aussparung (32) verbunden ist und eine Breite der zweiten Aussparung (32) kleiner als eine Breite der ersten Aussparung (31) ist,
der erste Kühlkörper (4) einen ersten Wärmeableitungsteil (41) und einen zweiten Wärmeableitungsteil (42) aufweist; der erste Wärmeableitungsteil (41) mit dem zweiten Wärmeableitungsteil (42) verbunden ist und eine Breite des zweiten Wärmeableitungsteils (42) kleiner als eine Breite des ersten Wärmeableitungsteils (41) ist,
das zweite Wärmeableitungsteil (42) in der zweiten Aussparung (32) angeordnet ist und das erste Wärmeableitungsteil (41) in der ersten Aussparung (31) angeordnet ist und auf einer Stufe an einer Übergangsverbindungsstelle zwischen der ersten Aussparung (31) und der zweiten Aussparung (32) getragen wird, und
das Verbindungssubstrat (2) auf dem ersten Wärmeableitungsteil (41) abgestützt ist.

2. Elektronisches Gehäuse nach Anspruch 1, wobei die zweite Aussparung (32) eine zweite Oberfläche des Gehäusesubstrats (1) durchdringt.

3. Elektronische Gehäuse nach Anspruch 2, ferner umfassend ein Wärmeableitungsloch, das in dem zweiten Wärmeableitungsteil (42) des ersten Kühlkörpers (4) zumindest entlang einer axialen Richtung des ersten Kühlkörpers (4) angeordnet ist.

4. Elektronisches Gehäuse nach einem der Ansprüche 1 bis 3, ferner umfassend: einen Versteifungsring (7), der auf dem Gehäusesubstrat (1) angeordnet ist; wobei der erste Chip (5) und der zweite Chip (6) in einem von dem Versteifungsring (7) umgebenen Raum angeordnet sind.

5. Elektronische Gehäuse nach Anspruch 4, ferner umfassend einen zweiten Kühlkörper (8), der auf dem Versteifungsring (7) getragen wird, wobei der zweite Kühlkörper (8) dem ersten Chip (5) und dem zweiten Chip (6) entspricht.

6. Elektronisches Gehäuse nach Anspruch 1, wobei,
das Gehäusesubstrat (1) umfasst:
eine erste Verbindungsschicht (11), wobei die erste Aussparung (31) in der ersten Verbindungsschicht (11) angeordnet ist, und die erste Verbindungsschicht (11) erste metallische Verdrahtungsschichten (111) und erste dielektrische Schichten (112) umfasst, die abwechselnd gestapelt sind;
das Verbindungssubstrat (2) umfasst:
eine zweite Verbindungsschicht (21), die zweite Metallverdrahtungsschichten und zweite dielektrische Schichten umfasst, die abwechselnd gestapelt sind, wobei die zweite dielektrische Schicht ein organisches Material umfasst, und eine Anordnungsdichte der zweiten Metallverdrahtungsschichten größer ist als eine Anordnungsdichte der ersten Metallverdrahtungsschichten (111),
wobei das organische Material vorzugsweise Polyimid umfasst.

7. Elektronisches Gehäuse nach Anspruch 6, wobei das Gehäusesubstrat (1) ferner umfasst:
eine Vielzahl von ersten Verbindungshöckern (12), die auf einer oberen Oberfläche der ersten Verbindungsschicht (11) angeordnet sind, wobei ein erster Chip, ein zweiter Chip und ein dritter Chip durch die ersten Verbindungshöcker (12) elektrisch mit dem Gehäusesubstrat (1) verbunden sind;
das Verbindungssubstrat (2) ferner eine Vielzahl von zweiten Verbindungshöckern aufweist, die auf einer oberen Oberfläche der zweiten Verbindungsschicht (21) angeordnet sind, wobei ein Teil des ersten Chips und ein Teil des zweiten Chips mit dem Verbindungssubstrat (2) durch die zweiten Verbindungshöcker elektrisch verbunden sind.

8. Elektronisches Gehäuse nach Anspruch 7, wobei,
eine Breite des zweiten Verbindungshügels kleiner ist als eine Breite des ersten Verbindungshügels (12); und/oder ein Abstand zwischen benachbarten zweiten Verbindungshügeln kleiner ist als ein Abstand zwischen benachbarten ersten Verbindungshügeln (12).

9. Elektronische Vorrichtung umfassend das elektronische Gehäuse nach einem der Ansprüche 1 bis 8 und eine Hauptplatine (9) für eine Baugruppe des elektronischen Gehäuses,
wobei das elektronische Gehäuse über das Gehäusesubstrat (1) elektrisch mit der Hauptplatine (9) verbunden ist.

10. Elektronische Vorrichtung nach Anspruch 9, wobei die Hauptplatine (9) an einer der Aussparung (3) entsprechenden Stelle mit einem ersten Durchgangsloch (10) versehen ist,
wobei vorzugsweise die Aussparung (3) eine zweite Oberfläche des Gehäusesubstrats (1) durchdringt und mit dem ersten Durchgangsloch (10) verbunden ist,
wobei außerdem vorzugsweise der erste Kühlkörper (4) in das erste Durchgangsloch (10) aus dem Gehäusesubstrat (1) herausgezogen ist.

11. Herstellungsverfahren für ein elektronisches Gehäuse, umfassend:
Bereitstellen eines Gehäusesubstrats (1) und Ausbilden einer Aussparung (3) auf einer ersten Oberfläche des Gehäusesubstrats (1);
Bereitstellen einer ersten Wärmesenke (4) und Einbetten der ersten Wärmesenke (4) in die Aussparung (3);
Bereitstellen eines Verbindungssubstrats (2), Einbetten des Verbindungssubstrats (2) in die Aussparung (3) und Anordnen des Verbindungssubstrats (2) auf dem ersten Kühlkörper (4); und
Bereitstellen von mindestens zwei Chips und elektrisches Verbinden jedes der mindestens zwei Chips mit dem Gehäusesubstrat (1) bzw. dem Verbindungssubstrat (2),
wobei das Ausbilden der Aussparung (3) auf der ersten Oberfläche des Gehäusesubstrats (1) umfasst:
Bilden einer ersten Aussparung (31) auf der ersten Oberfläche des Gehäusesubstrats (1); und
Ausbilden einer zweiten Aussparung (32) an einem Aussparungsboden der ersten Aussparung (31);
wobei die erste Aussparung (31) mit der zweiten Aussparung (32) verbunden ist, und eine Breite der zweiten Aussparung (32) kleiner ist als eine Breite der ersten Aussparung (31), wobei
der erste Kühlkörper (4) einen ersten Wärmeableitungsteil (41) und einen zweiten Wärmeableitungsteil (42) aufweist; der erste Wärmeableitungsteil (41) mit dem zweiten Wärmeableitungsteil (42) verbunden ist und eine Breite des zweiten Wärmeableitungsteils (42) kleiner als eine Breite des ersten Wärmeableitungsteils (41) ist,
das zweite Wärmeableitungsteil (42) in der zweiten Aussparung (32) angeordnet ist und das erste Wärmeableitungsteil (41) in der ersten Aussparung (31) angeordnet ist und auf einer Stufe an einer Übergangsverbindungsstelle zwischen der ersten Aussparung (31) und der zweiten Aussparung (32) getragen wird, und
das Verbindungssubstrat (2) auf dem ersten Wärmeableitungsteil (41) abgestützt ist.

12. Herstellungsverfahren für ein elektronisches Gehäuse nach Anspruch 11, wobei das Ausbilden der zweiten Aussparung (32) am Aussparungsboden der ersten Aussparung (31) umfasst:
Ausbilden der zweiten Aussparung (32), die durch eine zweite Oberfläche des Gehäusesubstrats (1) am Aussparungsgrund der ersten Aussparung (31) hindurchgeht.

13. Herstellungsverfahren für ein elektronisches Gehäuse nach Anspruch 11 oder 12, ferner umfassend:
Bereitstellen eines Versteifungsrings (7) und Befestigen des Versteifungsrings (7) auf dem Gehäusesubstrat (1); und
Bereitstellen eines zweiten Kühlkörpers (8) und Abstützen des zweiten Kühlkörpers (8) auf dem Versteifungsring (7),
wobei der zweite Kühlkörper (8) mit den mindestens zwei Chips korrespondiert.

## Revendications

1. Emballage électronique, comprenant un substrat d'emballage (1) et un substrat d'interconnexion (2), dans lequel une première surface du substrat d'emballage (1) est pourvue d'un évidement (3) dans lequel le substrat d'interconnexion (2) est intégré ; et un fond du substrat d'interconnexion (2) est pourvu d'un premier dissipateur thermique (4) ;
la première surface du substrat d'emballage (1) est pourvue d'une première matrice (5) et d'une seconde matrice (6) ; la première matrice (5) et la seconde matrice (6) sont connectées électriquement à travers le substrat d'interconnexion (2), dans lequel
l'évidement (3) comprend un premier évidement (31) et un second évidement (32), le premier évidement (31) est relié au second évidement (32), et une largeur du second évidement (32) est inférieure à une largeur du premier évidement (31),
le premier dissipateur thermique (4) comprend une première partie de dissipation thermique (41) et une seconde partie de dissipation thermique (42) ; la première partie de dissipation thermique (41) est reliée à la seconde partie de dissipation thermique (42), et une largeur de la seconde partie de dissipation thermique (42) est inférieure à une largeur de la première partie de dissipation thermique (41),
la seconde partie de dissipation thermique (42) est agencée dans le second évidement (32), et la première partie de dissipation thermique (41) est agencée dans le premier évidement (31) et supportée sur un escalier au niveau d'une jonction de transition entre le premier évidement (31) et le second évidement (32), et
le substrat d'interconnexion (2) est supporté sur la première partie de dissipation thermique (41).

2. Emballage électronique selon la revendication 1, dans lequel le second évidement (32) pénètre à travers une seconde surface du substrat d'emballage (1).

3. Emballage électronique selon la revendication 2, comprenant en outre un trou de dissipation thermique, qui est agencé dans la seconde partie de dissipation thermique (42) du premier dissipateur thermique (4) au moins le long d'une direction axiale du premier dissipateur thermique (4).

4. Emballage électronique selon l'une des revendications 1 à 3, comprenant en outre : un anneau raidisseur (7) agencé sur le substrat d'emballage (1) ; la première matrice (5) et la seconde matrice (6) sont agencées dans un espace entouré par l'anneau raidisseur (7).

5. Emballage électronique selon la revendication 4, comprenant en outre un second dissipateur thermique (8) supporté sur l'anneau raidisseur (7), dans lequel le second dissipateur thermique (8) correspond à la première matrice (5) et à la seconde matrice (6).

6. Emballage électronique selon la revendication 1, dans lequel,
le substrat d'emballage (1) comprend :
une première couche d'interconnexion (11), dans lequel le premier évidement (31) est agencé dans la première couche d'interconnexion (11), et la première couche d'interconnexion (11) comprend des premières couches de câblage métallique (111) et des premières couches diélectriques (112) qui sont empilées alternativement ;
le substrat d'interconnexion (2) comprend :
une seconde couche d'interconnexion (21), comprenant des secondes couches de câblage métallique et des secondes couches diélectriques qui sont empilées alternativement, dans lequel la seconde couche diélectrique comprend un matériau organique, et une densité d'agencement des secondes couches de câblage métallique est supérieure à une densité d'agencement des premières couches de câblage métallique (111),
de préférence, la matière organique comprend du polyimide.

7. Emballage électronique selon la revendication 6, dans lequel le substrat d'emballage (1) comprend en outre :
une pluralité de premières bosses de connexion (12) situées sur une surface supérieure de la première couche d'interconnexion (11), dans lequel une première puce, une deuxième puce et une troisième puce sont connectées électriquement au substrat d'emballage (1) à travers les premières bosses de connexion (12) ;
le substrat d'interconnexion (2) comprend en outre une pluralité de secondes bosses de connexion situées sur une surface supérieure de la seconde couche d'interconnexion (21), dans lequel une partie de la première puce et une partie de la deuxième puce sont connectées électriquement au substrat d'interconnexion (2) à travers les secondes bosses de connexion.

8. Emballage électronique selon la revendication 7, dans lequel
une largeur de la seconde bosse de connexion est inférieure à une largeur de la première bosse de connexion (12) ; et/ou une distance entre des secondes bosses de connexion adjacentes est inférieure à une distance entre des premières bosses de connexion (12) adjacentes.

9. Appareil électronique, comprenant l'emballage électronique selon l'une des revendications 1 à 8, et une carte mère (9) pour un assemblage de l'emballage électronique,
dans lequel l'emballage électronique est connecté électriquement à la carte mère (9) à travers le substrat d'emballage (1).

10. Appareil électronique selon la revendication 9, dans lequel la carte mère (9) est pourvue d'un premier trou traversant (10) au niveau d'une position correspondant à l'évidement (3),
de préférence, l'évidement (3) pénètre à travers une seconde surface du substrat d'emballage (1) et est relié au premier trou traversant (10),
en outre, de préférence, le premier dissipateur thermique (4) fait saillie dans le premier trou traversant (10) à partir du substrat d'emballage (1).

11. Procédé de fabrication d'un emballage électronique, comprenant :
la fourniture d'un substrat d'emballage (1), et la formation d'un évidement (3) sur une première surface du substrat d'emballage (1) ;
la fourniture d'un premier dissipateur thermique (4), et l'encastrement du premier dissipateur thermique (4) dans l'évidement (3) ;
la fourniture d'un substrat d'interconnexion (2), l'encastrement du substrat d'interconnexion (2) dans l'évidement (3), et l'agencement du substrat d'interconnexion (2) sur le premier dissipateur thermique (4) ; et
la fourniture d'au moins deux matrices, et la connexion électrique de chacune des au moins deux matrices avec le substrat d'emballage (1) et le substrat d'interconnexion (2), respectivement,
dans lequel la formation de l'évidement (3) sur la première surface du substrat d'emballage (1) comprend :
la formation d'un premier évidement (31) sur la première surface du substrat d'emballage (1) ; et
la formation d'un second évidement (32) au niveau d'un fond d'évidement du premier évidement (31) ;
dans lequel le premier évidement (31) est relié au second évidement (32), et une largeur du second évidement (32) est inférieure à une largeur du premier évidement (31), dans lequel
le premier dissipateur thermique (4) comprend une première partie de dissipation thermique (41) et une seconde partie de dissipation thermique (42) ; la première partie de dissipation thermique (41) est reliée à la seconde partie de dissipation thermique (42), et une largeur de la seconde partie de dissipation thermique (42) est inférieure à une largeur de la première partie de dissipation thermique (41),
la seconde partie de dissipation thermique (42) est agencée dans le second évidement (32), et la première partie de dissipation thermique (41) est agencée dans le premier évidement (31) et supportée sur un escalier au niveau d'une jonction de transition entre le premier évidement (31) et le second évidement (32), et
le substrat d'interconnexion (2) est supporté sur la première partie de dissipation thermique (41).

12. Procédé de fabrication d'un emballage électronique selon la revendication 11, dans lequel la formation du second évidement (32) au niveau du fond d'évidement du premier évidement (31) comprend :
la formation du second évidement (32) pénétrant à travers une seconde surface du substrat d'emballage (1) au niveau du fond d'évidement du premier évidement (31).

13. Procédé de fabrication d'un emballage électronique selon la revendication 11 ou 12, comprenant en outre :
la fourniture d'un anneau raidisseur (7) et la fixation de l'anneau raidisseur (7) sur le substrat d'emballage (1) ; et
la fourniture d'un second dissipateur thermique (8) et le support du second dissipateur thermique (8) sur l'anneau raidisseur (7),
dans lequel le second dissipateur thermique (8) correspond aux au moins deux matrices.
